# EUROPEAN PATENT APPLICATION

(11) **EP 4 372 985 A1**
(43) Date of publication of application: **22.05.2024**
(21) Application number: 22851850.2
(22) Date of filing: 14.07.2022
(51) Int. Cl.: H03F 1/56, H03F 1/02, H03F 3/195, H03F 3/213, H04B 1/04, H04B 1/18, H04B 1/40, H04L 27/00, H04L 27/20, H04L 27/22, H04W 88/08

(54) **POWER AMPLIFIER CIRCUIT, BASE STATION, SIGNAL TRANSCEIVER DEVICE, AND POWER AMPLIFIER APPARATUS**

(30) Priority: 04.08.2021 CN 202110891779
(71) Applicant: ZTE Corporation, Shenzhen, Guangdong 518057 (CN)
(72) Inventor: FENG, Pingli, Shenzhen, Guangdong 518057 (CN); DING, Chong, Shenzhen, Guangdong 518057 (CN); QIN, Tianyin, Shenzhen, Guangdong 518057 (CN); XIANG, Yang, Shenzhen, Guangdong 518057 (CN); ZHANG, Xiaoyi, Shenzhen, Guangdong 518057 (CN); WEI, Weiwei, Shenzhen, Guangdong 518057 (CN)
(74) Representative: Zoli, Filippo
(86) International application number: PCT/CN2022/105763
(87) International publication number: WO 2023/011136

(57) **Abstract**

A power amplifier circuit, a base station, a signal transceiver device, and a power amplifier apparatus. The power amplifier circuit comprises a main amplifier circuit and an auxiliary amplifier circuit connected in parallel between a signal input end and a signal output end. The main amplifier circuit comprises a first power amplifier and a second power amplifier connected in series, wherein the first power amplifier is a class-C power amplifier, and the second power amplifier is a class-AB power amplifier. The auxiliary amplifier circuit comprises a third power amplifier and a fourth power amplifier connected in series, wherein the third power amplifier is a class-AB power amplifier, and the fourth power amplifier is a class-C power amplifier.

## Description

### CROSS-REFERENCE TO RELATED APPLICATION

This application is filed on the basis of Chinese patent application No. 202110891779.0 filed August 04, 2021, and claims priority to the Chinese patent application, the entire contents of which are incorporated herein by reference.

### TECHNICAL FIELD

Embodiments of the present disclosure relate to the technical field of electronics, and in particular, to a power amplifier circuit, a base station, a signal transceiver device, and a power amplifier apparatus.

### BACKGROUND

Facing the increasingly fierce market competition, the performance of base station products is the main focus of competition in the industry. As an important part of the base station, the power amplifier unit is directly related to the quality of transmitted signals and the communication effect.

Conventional Doherty power amplifier is one of the most widely used power amplifier architecture at present, which includes a main power amplifier and an auxiliary power amplifier. To achieve effective load pulling and power combining, phases of two links where the main power amplifier and the auxiliary power amplifier are respectively located need to be aligned. In related technologies, phase alignment is implemented by adjusting the lengths of microstrip lines on two branches based on the center frequency of the power amplifier. However, because the electrical length of the microstrip line changes with the frequency, when the Doherty power amplifier is used in a broadband case, phase deviation occurs in operating bands far away from the center frequency point, affecting the efficiency and operating bandwidth of the power amplifier. In addition, because the main and auxiliary power amplifiers in conventional power amplifiers are of different types, e.g., a main driver-stage power amplifier, a main output-stage power amplifier, and an auxiliary driver-stage power amplifier are Class-AB power amplifiers, and an auxiliary output-stage power amplifier is a Class-C power amplifier, the phases of the main and auxiliary power amplifiers are not aligned at different power levels, affecting the operating efficiency at different power levels to a certain extent. At different power levels and different frequencies, the main and auxiliary power amplifiers have different gains. Such gain difference affects the performance of the power amplifier circuit. However, conventional phase compensation methods using microstrip lines cannot compensate for the phase difference and the gain difference.

### SUMMARY

The following is a summary of the subject matter set forth in the description. This summary is not intended to limit the scope of protection of the claims.

An embodiment of the present disclosure provides a power amplifier circuit to solve the problem of phase misalignment of conventional power amplifiers. The power amplifier circuit includes:
a main amplifier circuit and an auxiliary amplifier circuit, where the main amplifier circuit and the auxiliary amplifier circuit are connected in parallel between a signal input end of the power amplifier circuit and a signal output end of the power amplifier circuit;
the main amplifier circuit includes a first power amplifier and a second power amplifier connected in series, where the first power amplifier is a class-C power amplifier, and the second power amplifier is a class-AB power amplifier; and
the auxiliary amplifier circuit includes a third power amplifier and a fourth power amplifier connected in series, where the third power amplifier is a class-AB power amplifier, and the fourth power amplifier is a class-C power amplifier.

An embodiment of the present disclosure provides a base station, including the power amplifier circuit described in the above embodiment.

An embodiment of the present disclosure provides a signal transceiver device, including the power amplifier circuit described in the above embodiment.

An embodiment of the present disclosure provides a power amplifier apparatus, including the power amplifier circuit described in the above embodiment.

Additional features and advantages of the present disclosure will be set forth in the description which follows, and in part will be obvious from the description, or may be learned by the practice of the present disclosure. The objects and other advantages of the present disclosure can be realized and obtained by the structures particularly pointed out in the description, claims and drawings.

### BRIEF DESCRIPTION OF DRAWINGS

The drawings are provided for a further understanding of the technical schemes of the present disclosure, and constitute a part of the description. The drawings and the embodiments of the present disclosure are used to illustrate the technical schemes of the present disclosure, and do not constitute a limitation to the technical schemes of the present disclosure.
FIG. 1 is a block diagram of a power amplifier circuit in related technologies;
FIG. 2 is a block diagram of a power amplifier circuit according to an embodiment of the present disclosure;
FIG. 3 is a block diagram of a power amplifier circuit according to another embodiment of the present disclosure;
FIG. 4 is a block diagram of a band-pass filter according to an embodiment of the present disclosure;
FIG. 5 is a block diagram of a band-pass filter according to another embodiment of the present disclosure;
FIG. 6 is a diagram showing comparison of effects of a phase compensation module according to an embodiment of the present disclosure;
FIG. 7 is a block diagram of a phase modulation module according to an embodiment of the present disclosure;
FIG. 8 is a diagram showing comparison of effects of a phase modulation module according to an embodiment of the present disclosure;
FIG. 9 is a block diagram of an amplitude compensation module according to an embodiment of the present disclosure;
FIG. 10 is a diagram showing comparison of effects of an amplitude compensation module according to an embodiment of the present disclosure; and
FIG. 11 is a curve of power amplifier efficiency according to an embodiment of the present disclosure.

### DETAILED DESCRIPTION

To make the objectives, technical schemes, and advantages of the present disclosure clear, the present disclosure is described in further detail in conjunction with accompanying drawings and examples. It should be understood that the specific embodiments described herein are merely used for illustrating the present disclosure, and are not intended to limit the present disclosure.

It should be understood that in the description of the embodiments of the present disclosure, the term "a plurality of" (or multiple) means at least two, the terms such as "greater than", "less than", "exceed" and the like should be understood to not include the following number. The terms such as "above", "below", "within" and the like should be understood to include the following number. If used herein, the terms such as "first", "second" and the like are merely used for distinguishing technical features, and are not intended to indicate or imply relative importance, or implicitly point out the number of the indicated technical features, or implicitly point out the order of the indicated technical features.

Facing the increasingly fierce market competition, the performance of base station products is the main focus of competition in the industry. As an important part of the base station, the power amplifier unit is directly related to the quality of transmitted signals and the communication effect.

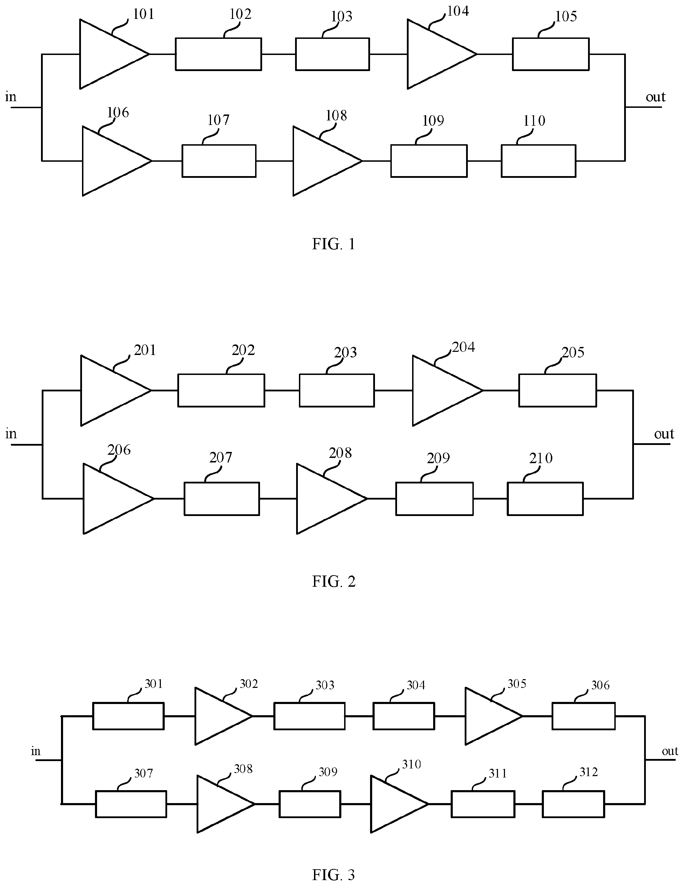

Doherty power amplifier is one of the most widely used power amplifier architecture at present, which includes a main power amplifier and an auxiliary power amplifier. To achieve effective load pulling and power combining, phases of the main power amplifier and the auxiliary power amplifier need to be aligned. FIG. 1 is a block diagram of a power amplifier circuit in related technologies. As shown in FIG. 1, a power amplifier circuit in related technologies includes a main amplifier circuit and an auxiliary amplifier circuit. The main amplifier circuit and the auxiliary amplifier circuit are connected in parallel between a signal input end of the power amplifier circuit and a signal output end of the power amplifier circuit. The main amplifier circuit includes a first power amplifier 101, a first compensation microstrip line 102, a first input matching network 103, a second power amplifier 104, and a first output matching network 105 connected in series in sequence. The auxiliary amplifier circuit includes a third power amplifier 106, a second input matching network 107, a fourth power amplifier 108, a second output matching network 109, and a second compensation microstrip line 110 connected in series in sequence. The first power amplifier 101 is a Class-AB power amplifier, and the second power amplifier 104 is a Class-AB power amplifier. The auxiliary amplifier circuit includes the third power amplifier 106 and the fourth power amplifier 108 connected in series. The third power amplifier 106 is a Class-AB power amplifier, and the fourth power amplifier 108 is a Class-C power amplifier. However, if the circuit structure of FIG. 1 is adopted, when the Doherty power amplifier operates in a broad band, phase deviation occurs in operating bands far away from the center frequency point, affecting the efficiency and operating bandwidth of the power amplifier. In addition, because the first power amplifier is a Class-AB power amplifier, the phases of the main and auxiliary power amplifiers are different at different power levels. Such phase difference affects the efficiency at different power levels to a certain extent. However, conventional phase compensation methods using microstrip lines cannot compensate for the phase difference. Therefore, due to the different operating modes of the main power amplifier and the auxiliary power amplifier and the frequency offset characteristics of the microstrip compensation lines, the power amplifier has the problem of phase misalignment.

Accordingly, embodiments of the present disclosure provide a power amplifier circuit and a power amplifier apparatus to solve the problem of phase misalignment of conventional power amplifiers.

FIG. 2 is a block diagram of a power amplifier circuit according to an embodiment of the present disclosure. As shown in FIG. 2, the power amplifier circuit provided in an embodiment of the present disclosure includes a main amplifier circuit and an auxiliary amplifier circuit. The main amplifier circuit and the auxiliary amplifier circuit are connected in parallel between a signal input end of the power amplifier circuit and a signal output end of the power amplifier circuit. The main amplifier circuit includes a first power amplifier 201 and a second power amplifier 204 connected in series. The first power amplifier 201 is a Class-C power amplifier, and the second power amplifier 204 is a Class-AB power amplifier. The auxiliary amplifier circuit includes a third power amplifier 206 and a fourth power amplifier 208 connected in series. The third power amplifier 206 is a Class-AB power amplifier, and the fourth power amplifier 208 is a Class-C power amplifier. In the block diagram of the circuit, the upper branch is a main circuit (the main amplifier circuit), and the lower branch is an auxiliary circuit (the auxiliary amplifier circuit).

In an embodiment, the main amplifier circuit further includes a first compensation microstrip line, a first input matching network, and a first output matching network. The first compensation microstrip line and the first input matching network are connected in series between the first power amplifier and the second power amplifier. The first output matching network is connected between the second power amplifier and the signal output end. The auxiliary amplifier circuit further includes a second compensation microstrip line, a second input matching network, and a second output matching network. The second compensation microstrip line and the second input matching network are connected in series between the third power amplifier and the fourth power amplifier. The second output matching network is connected between the fourth power amplifier and the signal output end. In this embodiment, a driver-stage power amplifier for driving the main circuit is a Class-C power amplifier, and a driver-stage power amplifier for driving the auxiliary circuit is a Class-AB power amplifier, which can compensate for the phase difference at the output stage at different power levels caused by inconsistent working modes, thereby achieving phase alignment at different power levels and improving the efficiency of the power amplifier circuit.

In an embodiment, as shown in FIG. 2, the power amplifier circuit provided in this embodiment includes a main amplifier circuit and an auxiliary amplifier circuit. The main amplifier circuit includes a first power amplifier 201, a first compensation microstrip line 202, a first input matching network 203, a second power amplifier 204, and a first output matching network 205 connected in series in sequence. The auxiliary amplifier circuit includes a third power amplifier 206, a second input matching network 207, a fourth power amplifier 208, a second output matching network 209, and a second compensation microstrip line 210 connected in series in sequence. It should be noted that in the power amplifier circuit provided in the embodiment of the present disclosure, the main amplifier circuit is connected in parallel with the auxiliary amplifier circuit, and a signal is input into the main amplifier circuit and the auxiliary amplifier circuit from the signal input end. In the main amplifier circuit, the signal passes through the first power amplifier 201, the first compensation microstrip line 202, the first input matching network 203, the second power amplifier 204, and the first output matching network 205 in sequence and is output through the signal output end. In the auxiliary amplifier circuit, the signal passes through the third power amplifier 206, the second input matching network 207, the fourth power amplifier 208, the second output matching network 209, and the second compensation microstrip line 210 in sequence and is then output through the signal output end.

It should be noted that the specific operating process of the power amplifier circuit provided in the embodiment of the present disclosure is as follows. A signal is input through the signal input end to the power amplifier circuit provided in the embodiment of the present disclosure. Then, the signal flows to the main amplifier circuit and the auxiliary amplifier circuit, respectively. In the main amplifier circuit, the signal passes through the first power amplifier, the first compensation microstrip line, the first input matching network, the second power amplifier, and the first output matching network in sequence and is then output through the signal output end. In the auxiliary amplifier circuit, the signal passes through the third power amplifier, the second input matching network, the fourth power amplifier, the second output matching network, and the second compensation microstrip line in sequence and is then output through the signal output end.

In the power amplifier circuit provided in the embodiment of the present disclosure, the types of power amplifiers in the main circuit and the auxiliary circuit are changed to allow the types of power amplifiers in the main circuit to be symmetrical to those in the auxiliary circuit. It should be noted that for the structure of conventional Doherty power amplifier circuits, the method of changing the types of power amplifiers in the main circuit and the auxiliary circuit in the embodiment of the present disclosure is feasible, while other different combinations of amplifier types will cause other problems. For example, in the embodiment of the present disclosure, a driver-stage power amplifier in the main power amplifier circuit is a Class-C power amplifier and an output-stage power amplifier in the main power amplifier circuit is a Class-AB power amplifier, while a driver-stage power amplifier in the auxiliary power amplifier circuit is a Class-AB power amplifier and an output-stage power amplifier in the auxiliary power amplifier circuit is a Class-C power amplifier. Correspondingly, if the driver-stage power amplifier in the main power amplifier circuit is a Class-AB power amplifier and the output-stage power amplifier in the main power amplifier circuit is a Class-C power amplifier, while the driver-stage power amplifier in the auxiliary power amplifier circuit is a Class-AB power amplifier, and the output-stage power amplifier in the auxiliary power amplifier circuit is a Class-C power amplifier, or if the driver-stage power amplifier in the main power amplifier circuit is a Class-AB power amplifier and the output-stage power amplifier in the main power amplifier circuit is a Class-C power amplifier, while the driver-stage power amplifier in the auxiliary power amplifier circuit is a Class-AB power amplifier, and the output-stage power amplifier in the auxiliary power amplifier circuit is a Class-C power amplifier, problems such as unstable amplification current or amplification voltage occur in the conventional Doherty power amplifier circuit architecture, which is caused by the conventional Doherty power amplifier circuit architecture. Therefore, in the embodiment of the present disclosure, the driver-stage power amplifier in the main power amplifier circuit is a Class-C power amplifier and the output-stage power amplifier in the main power amplifier circuit is a Class-AB power amplifier, while the driver-stage power amplifier in the auxiliary power amplifier circuit is a Class-AB power amplifier and the output-stage power amplifier in the auxiliary power amplifier circuit is a Class-C power amplifier. Based on the conventional Doherty power amplifier circuit architecture, such a combination can effectively solve the problems of phase misalignment and amplitude difference in the power amplifier circuit, thereby improving the performance of the power amplifier circuit.

The input signal may be a radio frequency signal or other electrical signals, i.e., the power amplifier circuit provided in the embodiment of the present disclosure can be applied to all electrical signals that can be processed and amplified by a conventional Doherty power amplifier circuit, including radio frequency signals.

The signal processing procedure of this embodiment is as follows. An input signal is input from the signal input end into the power amplifier circuit provided in this embodiment. After being input into the power amplifier circuit provided in this embodiment, the input signal is divided into two paths. One of the paths enters the main power amplifier circuit and the other path enters the auxiliary power amplifier circuit. In the main power amplifier circuit, the input signal first passes through the first signal amplifier, then passes through the first compensation microstrip line, the first input matching network, the second power amplifier, and the first output matching network in sequence, and is then output through the signal output end. In the auxiliary power amplifier circuit, the input signal first passes through the third signal amplifier, then passes through the second compensation microstrip line, the second input matching network, the fourth power amplifier, the second output matching network, and the second compensation microstrip line in sequence, and is then output through the signal output end. In this embodiment, the first power amplifier in the main amplifier circuit in the conventional power amplifier circuit is changed from the original Class-AB to Class C, to compensate for the phase difference at the output stage of the power amplifier circuit at different power levels caused by inconsistent operating modes, thereby achieving phase alignment at different power levels and improving the efficiency of the power amplifier circuit.

In an embodiment, as shown in FIG. 3, FIG. 3 is another block diagram of a power amplifier circuit according to an embodiment of the present disclosure. The main amplifier circuit in the power amplifier circuit provided in the embodiment of the present disclosure further includes: a phase compensation module, arranged between the signal input end and the first power amplifier to perform phase compensation on an input signal; and an amplitude compensation module, arranged between the signal input end and the third power amplifier to perform amplitude compensation on the input signal. It should be noted that based on FIG. 2, the phase compensation module and the amplitude compensation module are additionally provided in FIG. 3. In FIG. 3, the phase compensation module is arranged preceding to the first power amplifier, and two ends of the phase compensation module are respectively connected to the first power amplifier and the signal input end. The amplitude compensation module is arranged preceding to the third power amplifier, and two ends of the amplitude compensation module are respectively connected to the third power amplifier and the signal input end.

In an embodiment, the phase compensation module includes a band-pass filter and a phase modulation module. The band-pass filter and the phase modulation module are connected in series, the band-pass filter is connected to the signal input end, and the phase modulation module is connected in series with the first power amplifier. The phase compensation module is implemented in the form of a band-pass filter. Band-pass filters of different orders may be used to implement different degrees of phase compensation, to solve the frequency offset problem caused by compensation using microstrip lines in the conventional Doherty power amplifier circuit architecture. The phase modulation module implemented in the form of a four-port bridge circuit to achieve precise signal phase adjustment. The phase compensation module is composed of a band-pass filter and a phase modulation module. The band-pass filter and the phase modulation module are arranged in series in the power amplifier circuit provided in the embodiment of the present disclosure. In the main power amplifier circuit, the band-pass filter is connected in series between the signal input end and the phase modulation module, and the phase modulation module is connected in series between the band-pass filter and the first power amplifier. In the auxiliary power amplifier circuit, a band-pass filter is connected in series between the signal input end and a phase modulation module, and the phase modulation module is connected in series between the band-pass filter and the third power amplifier. It should be noted that the band-pass filter and the phase modulation module in the phase compensation module in the power amplifier circuit provided in the embodiment of the present disclosure have different functions. The band-pass filter needs to perform preliminary phase compensation on the input signal, to make phases of the input signal substantially consistent. Then, the processed input signal enters the phase modulation module. The phase modulation module performs a more accurate adjustment on the input signal. Compared with conventional power amplifier circuits, the power amplifier circuit provided in the embodiment of the present disclosure includes the phase compensation module additionally provided to effectively perform phase compensation on the signal, making the phases of the signal remain consistent and the frequencies of the signal remain aligned.

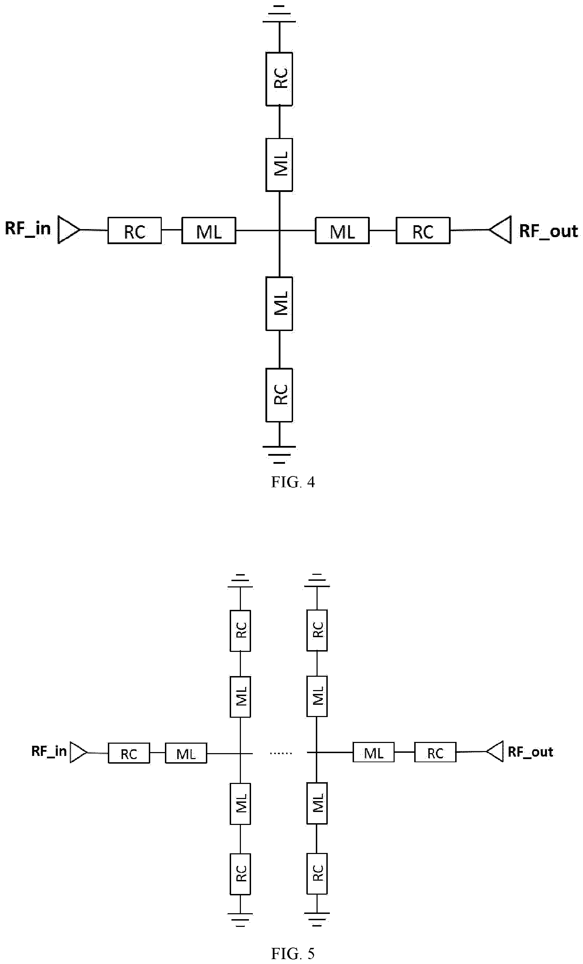

In an embodiment, as shown in FIG. 4, FIG. 4 is a block diagram of a band-pass filter according to an embodiment of the present disclosure. In FIG. 4, RC represents a reactance element and ML represents a microstrip line. In this embodiment, the band-pass filter in the phase compensation module includes a cross-shaped stub composed of a microstrip line. The cross-shaped stub includes a horizontal stub and a vertical stub, two ends of the horizontal stub are respectively connected to reactance elements, and two ends of the vertical stub are respectively grounded through reactance elements. A number of the vertical stubs in the band-pass filter in this embodiment is greater than or equal to 1. It should be noted that the number of vertical stubs in the band-pass filter provided in this embodiment may be more than one. As shown in FIG. 5, the number of vertical stubs in the band-pass filter in this embodiment may be two or more. Flexible phase compensation can be implemented to meet different requirements by changing the number of vertical stubs in the band-pass filter. In this embodiment, the number of vertical stubs may further be increased to implement flexible phase compensation to meet different requirements in different application scenarios. Therefore, phase compensation of different frequencies can be effectively implemented by arranging different numbers of vertical stubs in the band-pass filter in the power amplifier circuit provided in this embodiment.

The operating process of the band-pass filter provided in this embodiment is as follows. The input signal is input from the signal input end into the band-pass filter and enters the cross-shaped stub band-pass filter shown in FIG. 4 or FIG. 5. After the input signal passes through the horizontal stub and the vertical stub, the processed signal is output through the signal output port at the end of the horizontal stub.

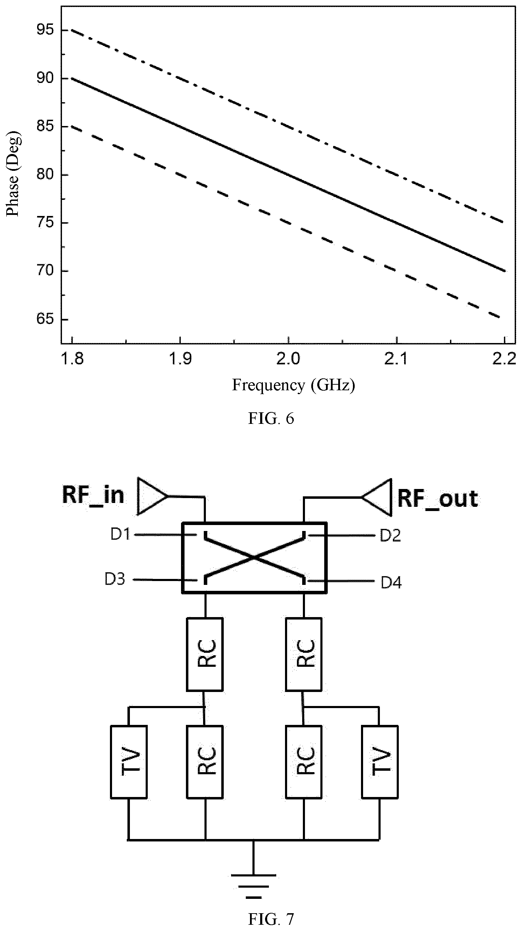

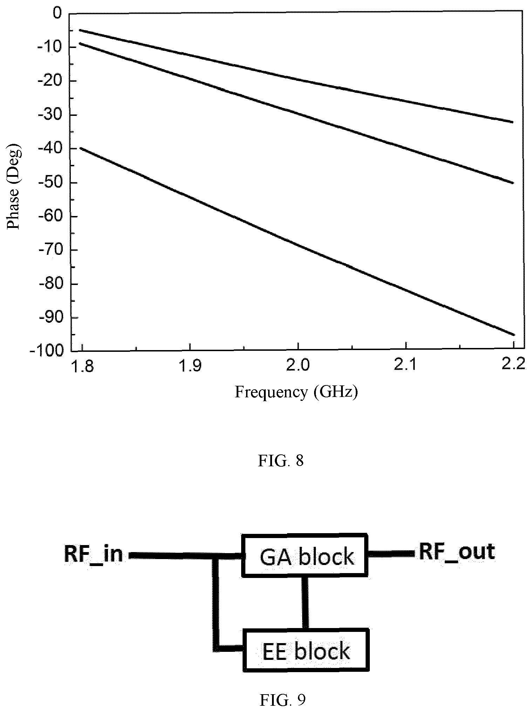

FIG. 6 is a diagram showing comparison of effects of a phase compensation module according to an embodiment of the present disclosure, with frequency measured in GHz as the abscissa of FIG. 9 and phase measured in degrees (Deg) as the ordinate. As shown in FIG. 6, three curves are phase-frequency curves obtained by band-pass filters with different numbers of vertical stubs. As can be seen from FIG. 6, the phase compensation module provided in the embodiment of the present disclosure can compensate for phases ranging from 7°/100 MHz to 20°/100 MHz using band-pass filters with different numbers of vertical stub numbers.

In an embodiment, as shown in FIG. 7, FIG. 7 is a block diagram of a phase modulation module according to an embodiment of the present disclosure. In FIG. 7, TV represents a tunable variable capacitance diode and RC represents a reactance element. In this embodiment, the phase modulation module includes a four-port bridge. The four-port bridge includes a first port D1, a second port D2, a third port D3, and a fourth port D4. The first port is an input end, and the second port is an output end. The third port is grounded after being connected to a first branch, and the fourth port is grounded after being connected to a second branch. The first branch includes a first reactance element, a second reactance element, and a first tunable variable capacitance diode. The first reactance element and the first tunable variable capacitance diode are connected in series with the second reactance element after being connected in parallel. The second reactance element is connected to the third port. The second branch includes a third reactance element, a fourth reactance element, and a second tunable variable capacitance diode. The third reactance element and the second tunable variable capacitance diode are connected in series with the fourth reactance element after being connected in parallel. The fourth reactance element is connected to the fourth port. The operating process of the phase modulation module provided in this embodiment is as follows. The input signal is input from the signal input end into the phase modulation module and enters the four-port bridge shown in FIG. 7. The input signal is input into the four-port bridge from the first port, and then passes through the two branches each formed by a reactance element and a tunable variable capacitance diode connected in parallel. The two branches are respectively connected to the third port and the fourth port. A specific parallel structure and connection mode are shown in FIG. 7. Then, the processed input signal is output through the second port. The phase adjustment module provided in this embodiment is implemented based on a bridge having four ports, where two ports are configured for signal input and output, and the other two ports are each connected to a circuit formed by reactance elements and a variable capacitance diode connected in series and parallel. The phase of the branch where the phase compensation module is located can be changed by adjusting a parameter of the variable capacitance diode, thereby achieving more accurate phase compensation.

In the phase modulation module provided in this embodiment, the phase of the branch where the phase compensation module is located can be changed by adjusting parameters of the first tunable variable capacitance diode and the second tunable variable capacitance diode, thereby achieving more accurate phase compensation. FIG. 8 is a diagram showing comparison of effects of a phase modulation module according to an embodiment of the present disclosure, with frequency measured in GHz as the abscissa and phase measured in degrees (Deg) as the ordinate. As shown in FIG. 8, two dashed lines are phase-frequency curves obtained after parameters of the variable capacitance diodes are adjusted, and a solid line is a phase-frequency curve obtained without adjusting parameters of the variable capacitance diodes. As can be seen from FIG. 8, after the phase modulation module in the above embodiment is additionally provided, the phase can be adjusted within ±5° in the operating band by adjusting the parameters of the variable capacitance diodes, indicating that the phase modulation module provided in the embodiment of the present disclosure has a phase adjustment function.

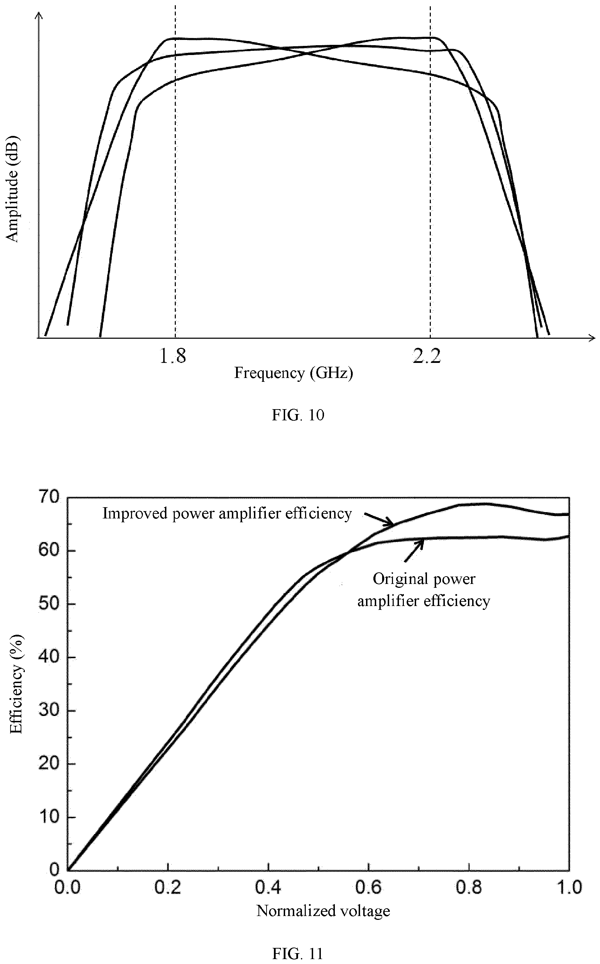

In an embodiment, as shown in FIG. 9, FIG. 9 is a block diagram of an amplitude compensation module according to an embodiment of the present disclosure. The amplitude compensation module in the power amplifier circuit provided in the embodiment of the present disclosure includes an envelope extraction module (EE block) and a gain attenuation bridge (GA block). A signal is divided into two paths after being input from an input end of the amplitude compensation module. One of the paths is input to the envelope extraction module and then output through the gain attenuation bridge, and the other path is input to the envelope extraction module and then output. The envelope extraction module is configured for extracting an envelope of the input signal, where the envelope of the input signal is an amplitude-time curve of the input signal. The gain attenuation bridge is a dynamics processor for signal gains. A gain of the gain attenuation bridge varies with the signal. Therefore, the gain attenuation bridge can effectively adjust the amplitude gain of the input signal to implement amplitude compensation on the input signal. FIG. 10 is a diagram showing comparison of effects of an amplitude compensation module according to an embodiment of the present disclosure, with frequency measured in GHz as the abscissa and amplitude measured in dB as the ordinate. As shown in FIG. 10, three amplitude-frequency curves are obtained by adjusting a parameter of the band-pass filter in the amplitude compensation module. As can be seen from FIG. 10, the amplitude compensation module provided in the embodiment of the present disclosure can implement gain compensation in the operating band by adjusting the parameter of the band-pass filter.

The operating process of the amplitude compensation module provided in this embodiment is as follows. The input signal is input from the signal input end into the amplitude compensation module provided in the embodiment of the present disclosure. After being input from the input end of the amplitude compensation module, the input signal is divided into two paths. One of the paths is input to the envelope extraction module and then output through the gain attenuation bridge, and the other path is input to the envelope extraction module and then output. In this embodiment, the amplitude compensation module is mainly composed of the envelope extraction module and the gain attenuation bridge, a corresponding signal envelope is obtained through the envelope extraction module, and the output of the amplitude compensation module is controlled according to the extracted envelope, to implement gain compensation at different power levels.

The operating process of the power amplifier circuit provided in the present disclosure is as follows. The input signal is input from the signal input end into the power amplifier circuit provided in the above embodiment of the present disclosure. The input signal is divided into two paths which respectively flow into the main circuit of the power amplifier circuit and the auxiliary circuit of the power amplifier circuit. In the main circuit of the power amplifier circuit, the signal first passes through the phase compensation module, and then passes through the first power amplifier, the first compensation microstrip line, the first input matching network, the second power amplifier, and the first output matching network in sequence. In the auxiliary circuit of the power amplifier circuit, the signal first passes through the phase compensation module, and then passes through the third power amplifier, the second input matching network, the fourth power amplifier, the second output matching network, and the second compensation microstrip line in sequence. The function of the phase compensation module is to perform phase compensation on the input signal, to solve the frequency offset problem caused by compensation using microstrip lines in conventional amplifier circuits. The first power amplifier and the third power amplifier serve as driver-stage power amplifiers to drive the power amplifier circuit to operate. The compensation microstrip line serves to compensate for the signal frequency in a conventional manner. The second power amplifier and the fourth power amplifier serve to amplify the current, voltage, power, etc., of the signal, to realize functions of a power amplifier. The power amplifier circuit provided in this embodiment can achieve phase alignment at different powers while amplifying the input signal, thereby improving the performance of the power amplifier circuit. In this embodiment, the phase compensation module and the amplitude compensation module are respectively additionally provided between the first power amplifier and the signal input end and between the third power amplifier and the signal input end to implement signal phase compensation, thereby solving the frequency offset problem caused by compensation using microstrip lines in the conventional Doherty power amplifier circuit architecture. Auxiliary-circuit gain compensation at different frequencies can be implemented according to a slope of the amplitude-frequency curve of the transmission parameter in the pass band of the band-pass filter, thereby achieving better load pulling. FIG. 11 is a curve of power amplifier efficiency according to an embodiment of the present disclosure, with normalized voltage as the abscissa and power amplifier efficiency as the ordinate. As shown in FIG. 11, original power amplifier efficiency represents a power amplifier efficiency curve obtained without the phase compensation module provided in the embodiments of the present disclosure, and improved power amplifier efficiency represents a power amplifier efficiency curve obtained with the arrangement of the phase compensation module provided in the embodiments of the present disclosure. As can be seen from FIG. 11, after the phase compensation module is additionally provided, the efficiency of the power amplifier circuit in high-power regions is significantly improved.

In an embodiment, the present disclosure further provides a base station, including the power amplifier circuit in the above embodiment.

In an embodiment, the present disclosure further provides a signal transceiver device, including the power amplifier circuit in the above embodiment.

In an embodiment, the present disclosure further provides a power amplifier apparatus, including the power amplifier circuit in the above embodiment.

Beneficial effects of the embodiments of the present disclosure are as follows. The main amplifier circuit and the auxiliary amplifier circuit are connected in parallel between the signal input end of the power amplifier circuit and the signal output end of the power amplifier circuit. To be specific, the main amplifier circuit includes a first power amplifier and a second power amplifier connected in series. The first power amplifier is a class-C power amplifier, and the second power amplifier is a class-AB power amplifier. The auxiliary amplifier circuit includes a third power amplifier and a fourth power amplifier connected in series. The third power amplifier is a class-AB power amplifier, and the fourth power amplifier is a class-C power amplifier. The above circuit structure changes the operating mode of the power amplifier, and effectively solves the problem of phase misalignment in conventional power amplifier circuits.

Those having ordinary skills in the art can understand that all or some of the steps in the methods disclosed above and the functional modules/units in the system and the apparatus can be implemented as software, firmware, hardware, and appropriate combinations thereof. Some or all physical components may be implemented as software executed by a processor, such as a central processing unit, a digital signal processor, or a microprocessor, or as hardware, or as an integrated circuit, such as an application-specific integrated circuit.

Although some embodiments of the present disclosure have been described above, the present disclosure is not limited to the implementations described above. Those having ordinary skills in the art can make various equivalent modifications or replacements without departing from the essence of the present disclosure. Such equivalent modifications or replacements fall within the scope defined by the claims of the present disclosure.

## Claims

1. A power amplifier circuit, comprising:
a main amplifier circuit and an auxiliary amplifier circuit, wherein the main amplifier circuit and the auxiliary amplifier circuit are connected in parallel between a signal input end of the power amplifier circuit and a signal output end of the power amplifier circuit;
the main amplifier circuit comprises a first power amplifier and a second power amplifier connected in series, wherein the first power amplifier is a class-C power amplifier, and the second power amplifier is a class-AB power amplifier; and
the auxiliary amplifier circuit comprises a third power amplifier and a fourth power amplifier connected in series, wherein the third power amplifier is a class-AB power amplifier, and the fourth power amplifier is a class-C power amplifier.

2. The power amplifier circuit of claim 1, wherein the main amplifier circuit further comprises:
a phase compensation module, arranged between the signal input end and the first power amplifier to perform phase compensation on an input signal.

3. The power amplifier circuit of claim 2, wherein the phase compensation module comprises a band-pass filter and a phase modulation module, wherein the band-pass filter and the phase modulation module are connected in series, the band-pass filter is connected to the signal input end, and the phase modulation module is connected in series with the first power amplifier.

4. The power amplifier circuit of claim 3, wherein the band-pass filter comprises a cross-shaped stub composed of a microstrip line, wherein the cross-shaped stub comprises a horizontal stub and a vertical stub, two ends of the horizontal stub are respectively connected to reactance elements, and two ends of the vertical stub are respectively grounded through reactance elements.

5. The power amplifier circuit of claim 4, wherein a number of the vertical stubs is greater than or equal to 1.

6. The power amplifier circuit of claim 3, wherein the phase modulation module comprises a four-port bridge, wherein the four-port bridge comprises a first port, a second port, a third port, and a fourth port;
the first port is an input end, and the second port is an output end;
the third port is grounded after being connected to a first branch, and the fourth port is grounded after being connected to a second branch;
the first branch comprises a first reactance element, a second reactance element, and a first tunable variable capacitance diode, wherein the first reactance element and the first tunable variable capacitance diode are connected in series with the second reactance element after being connected in parallel, and the second reactance element is connected to the third port; and
the second branch comprises a third reactance element, a fourth reactance element, and a second tunable variable capacitance diode, wherein the third reactance element and the second tunable variable capacitance diode are connected in series with the fourth reactance element after being connected in parallel, and the fourth reactance element is connected to the fourth port.

7. The power amplifier circuit of claim 1, further comprising:
an amplitude compensation module, arranged between the signal input end and the third power amplifier to perform amplitude compensation on an input signal.

8. The power amplifier circuit of claim 7, wherein the amplitude compensation module comprises an envelope extraction module and a gain attenuation bridge, and a signal is divided into two paths after being input from an input end of the amplitude compensation module, wherein one of the paths is input to the envelope extraction module and then output through the gain attenuation bridge, and the other path is input to the envelope extraction module and then output.

9. The power amplifier circuit of claim 1, wherein the main amplifier circuit further comprises a first compensation microstrip line, a first input matching network, and a first output matching network, wherein the first compensation microstrip line and the first input matching network are connected in series between the first power amplifier and the second power amplifier, and the first output matching network is connected between the second power amplifier and the signal output end.

10. The power amplifier circuit of claim 1, wherein the auxiliary amplifier circuit further comprises a second compensation microstrip line, a second input matching network, and a second output matching network, wherein the second compensation microstrip line and the second input matching network are connected in series between the third power amplifier and the fourth power amplifier, and the second output matching network is connected between the fourth power amplifier and the signal output end.

11. A base station, comprising the power amplifier circuit of any one of claims 1 to 10.

12. A signal transceiver device, comprising the power amplifier circuit of any one of claims 1 to 10.

13. A power amplifier apparatus, comprising the power amplifier circuit of any one of claims 1 to 10.
